Europäisches Patentamt

European Patent Office

Office européen des brevets

(11) Veröffentlichungsnummer:

**0 095 658**
A2

(12) ## EUROPÄISCHE PATENTANMELDUNG

(21) Anmeldenummer: 83104901.0

(22) Anmeldetag: 18.05.83

(51) Int. Cl.³: **H 01 L 29/06**

(30) Priorität: 27.05.82 DE 3219888

(43) Veröffentlichungstag der Anmeldung: 07.12.83
Patentblatt 83/49

(84) Benannte Vertragsstaaten: **DE FR GB IT NL**

(71) Anmelder: **Deutsche ITT Industries GmbH,**
**Hans-Bunte-Strasse 19 Postfach 840, D-7800 Freiburg**
**(DE)**

(84) Benannte Vertragsstaaten: **DE**

(71) Anmelder: **ITT INDUSTRIES INC., 320 Park Avenue, New**
**York, NY 10022 (US)**

(84) Benannte Vertragsstaaten: **FR GB IT NL**

(72) Erfinder: **Adam, Fritz Günter, Dr.rer.nat.Dipl.-Phys.,**
**Furtwänglerstrasse 10, D-7800 Freiburg i.Br. (DE)**

(74) Vertreter: **Stutzer, Gerhard, Dr., Deutsche ITT Industries**
**GmbH Patent- und Lizenzabteilung**
**Hans-Bunte-Strasse 19 Postfach 840, D-7800 Freiburg**
**(DE)**

(54) Planares Halbleiterbauelement und Verfahren zur Herstellung.

(57) Die Durchbruchspannung der pn-Übergänge bei Planarstrukturen wird dadurch erhöht, daß eine im Halbleiterkörper (4) angeordnete Zone (1) von zu diesem entgegengesetzten Leitungstyp ringförmig von weiteren Zonen (2...n) ihres Leitungstyps und mit nach außen hin abnehmender Dotierungskonzentration umgeben ist.

EP 0 095 658 A2

F. G. Adam 54

Fl 1135 EP
Dr. Rl/Be
17. Mai 1983

Planares Halbleiterbauelement und Verfahren zur Herstellung

Die Erfindung betrifft ein planares Halbleiterbauelement nach dem Oberbegriff des Anspruchs 1 sowie ein Verfahren zu dessen Herstellung.

Bei Planarstrukturen, wie sie z.B. Planartransistoren darstellen, wird die Durchbruchspannung der pn-Übergänge durch den kleinsten Krümmungsradius am Rande der umdotierten Zone und damit durch den kleinsten Krümmungsradius des Verlaufs der Raumladungszone bestimmt. Je flacher der Übergang und damit je kleiner der Krümmungsradius desto kleiner die Durchbruchspannung.

Es ist bekannt, daß die Durchbruchspannung derartiger pn-Übergänge durch eine sogenannte Feldplatte vergrößert werden kann. Man versteht darunter eine Metallisierung, die im Kontakt mit dem Diffusionsgebiet steht und die dessen Rand, auf Oxid liegend, ein Stück überlappt. Eine derartige Feldplatte beansprucht auf der Oberfläche des Halbleiterbauelements einen gewissen Raum, deshalb wird man sie bei bestimmten Fällen, wie z.B. integrierten Schaltkreisen, nicht gerne verwenden, da der von ihr beanspruchte Platz für Leiterbahnen verwendet werden könnte.

Aus der DE-OS 29 44 937 ist ein planares Halbleiterbauelement bekannt, das bei geringer Diffusions- bzw. Implantationstiefe eine hohe Durchbruchspannung besitzt. Man erreicht dies dort durch einen im Abstand zum pn-Übergang vorgesehenen Schutzring und einen die Isolierschicht

F. G. Adam 54                                   Fl 1135 EP

überdeckenden Film, der halbisolierend ist und mindestens
zwei Bereiche mit einem genau festgelegten Potential
hat. Wird der Film nun auf zwei verschiedenen Potentialen
gehalten, so erhält die Raumladungszone einen Verlauf,
der sich durch große Krümmungsradien auszeichnet, so daß
das bekannte Halbleiterbauelement große Durchbruchspannungen
besitzt.

Die Erfindung, wie sie in den Ansprüchen gekennzeichnet ist,
löst die Aufgabe, die Durchbruchspannung von pn-Übergängen
ohne Verwendung einer Feldplatte bzw. auf gegenüber der oben
genannten Druckschrift wesentlich einfachere Weise zu
erhöhen. Hierin liegt ein Vorteil der Erfindung.

Die vorliegende Erfindung löst das Problem durch eine
in dem Halbleiterkörper angeordnete Zone von zu diesem
entgegengesetztem Leitungstyp, die ringförmig von weiteren
Zonen ihres Leitungstyps und abnehmender Dotierungskonzentration umgeben ist. Die Wirkung einer Feldplatte
bezüglich der Erhöhung der Durchbruchspannung läßt sich
ohne weiters übertreffen, man kann jedoch auch in geeigneter
Weise mit Vorteil eine Feldplatte mit der vorliegenden
Erfindung kombinieren, worin ein weiterer Vorteil der
Erfindung liegt.

Die Erfindung wird nachstehend anhand zweier Ausführungsbeispiele in Verbindung mit den Figuren näher erläutert.

Fig. 1 bis 3 zeigen Schnitte durch ein erstes Ausführungsbeispiel der Erfindung,
Fig. 4      zeigt den Schnitt durch ein zweites Ausführungsbeispiel der Erfindung.

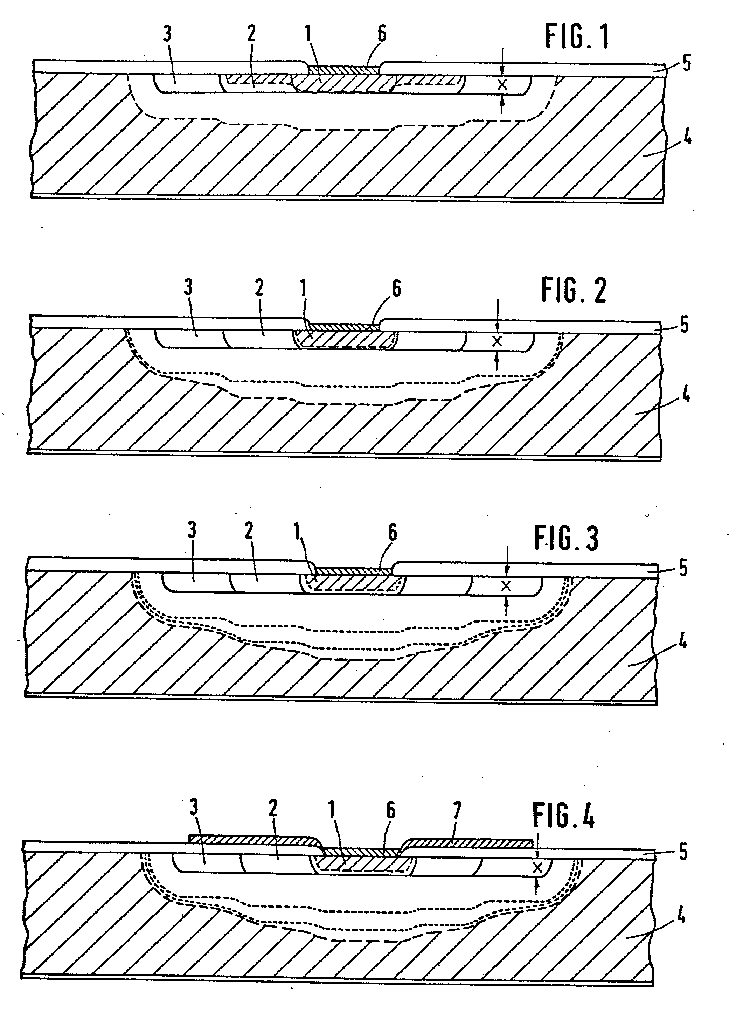

Fig. 1 zeigt einen Halbleiterkörper 4 mit der Dotierung NO,
in das die drei Zonen 1, 2, 3 von zum Halbleiterkörper
entgegengesetztem Leitungstyp eingelassen sind. Halbleiter-

0095658

F. G. Adam 54 Fl 1135 EP

körper und Zonen und damit der pn-Übergang sind mit einer Isolierschicht 5 aus z.B. $SiO_2$ abgedeckt, wobei sich im Bereich der Zone 1 in der Isolierschicht 5 ein Fenster befindet, in dem eine Elektrode 6 angeordnet ist. Die Zonen 3 und 2 sind ringförmig um die Zone 1 angeordnet und weisen eine der nachstehenden Gleichung entsprechende abnehmende Dotierung auf:

$$NO \leq N3 < N2 < N1.$$

Vorzugsweise haben alle drei Zonen 1 bis 3 etwa die gleiche Eindringtiefe X, d. h. X1 = X2 = X3. Möglich ist jedoch auch folgendes Verhältnis der Eindringtiefen X:

$$X1 < X2 < X3.$$

Die Raumladungszone liegt in Fig. 1 zwischen den schraffierten quasineutralen Gebieten. Legt man eine Spannung U3 an die Elektrode 6, so wird die äußerste Zone 3 mit der Dotierung N3 gerade ausgeräumt, beim Anlegen der Spannung U2 die nächstfolgende Zone 2 mit der Dotierung N2, und für die Durchbruchspannung Ud gilt dann $Ud \geq U1 > U2 > U3$. Die Fig. 2 und 3 zeigen die Ausbreitung der Raumladungszone in Abhängigkeit von der angelegten Spannung. Durch die damit verbundene Vergrößerung der lateralen Ausdehnung der Raumladungszone kommt es zur Erhöhung der Durchbruchspannung.

Das Ausführungsbeispiel enthält 3 ringförmige Zonen, eine höhere Zahl ist natürlich ebenfalls möglich.

Die laterale Breite der ringförmigen Zonen kann je nach Eindringtiefe, Substratdotierung und Zahl n der Zonen im Bereich von 5 bis 20 μm liegen. Je höher die Zahl n, desto schmäler kann die einzelne Zone ausfallen.

F. G. Adam 54                                    Fl 1135 EP

Ein Halbleiterbauelement gemäß dem in den Fig. 1 bis 3 gezeigten Ausführungsbeispiel läßt sich wie folgt herstellen:

Unter Verwendung einer entsprechend dimensionierten Maske wird in einem z.B. n-leitenden Halbleiterkörper 4 mit einer Dotierungskonzentration NO die Zone 3 durch z. B. Ionenimplan-tation erzeugt. Danach wird mittels einer neuen Maske mit kleinerer Öffnung innerhalb der Zone 3 die Zone 2 und schließlich zuletzt mit einer Maske mit der kleinsten Öffnung die Zone 1 innerhalb der Zone 2 erzeugt. Die Zonen sind gegenüber dem Substrat von entgegengesetztem Leitungstyp und werden z.B. durch Bor-Ionenimplantation erzeugt, wobei die Reaktionsbedingungen bezüglich Eindringtiefe und Dotierungskonzentration so gewählt werden, daß erstere stets gleich oder kleiner als die der Zone 3 ist, während die Dotierungskonzentrationen so gewählt werden, daß ein Gefälle von der Zone 1 zur Zone 3 hin besteht. Nach dem Aufbringen einer Isolierschicht wird im Bereich der Zone 1 ein Fenster geöffnet und eine Elektrode 6 angebracht. Diese Maßnahmen werden nach einem der herkömmlichen Verfahren durchgeführt.

Fig. 4 zeigt ein Halbleiterbauelement nach Fig. 1, das neben der erfindungsgemäßen Struktur eine Feldplatte 7 aufweist.

0095658

F. G. Adam 54

Fl 1135 EP
Dr. Rl/Be
17. Mai 1983

## Patentansprüche

1. Planares Halbleiterbauelement mit mindestens einem pn-Übergang in einem Halbleiterkörper (4) des einen Leitungstyps, auf dem eine Isolierschicht (5) angeordnet ist, die den an die Oberfläche des Halbleiterkörpers tretenden pn-Übergang überdeckt, dadurch gekennzeichnet, daß eine in dem Halbleiterkörper (4) angeordnete Zone (1) vom entgegengesetzten Leitungstyp ringförmig von einer oder mehreren Zone(n) (2...n) vom entgegengesetzten Leitungstyp und mit von Zone zu Zone nach außen hin abnehmender Dotierungskonzentration umgeben ist.

2. Planares Halbleiterbauelement nach Anspruch 1, gekennzeichnet durch gleiche Eindringtiefe der Zonen (1...n) in dem Halbleiterkörper (4).

3. Verfahren zur Herstellung eines Halbleiterbauelements nach den Ansprüchen 1 und 2, dadurch gekennzeichnet, daß unter Verwendung unterschiedlicher Masken, ausgehend von der Maske mit der gewünschten größtmöglichen Öffnung bis hin zur Maske mit der gewünschten kleinsten Öffnung zeitlich nacheinander Ionen gleicher Art mit zunehmender Konzentration unter gleichen Bedingungen implantiert und damit die Zonen (1...n) hergestellt werden.

0095658

FIG.1

FIG.2

FIG.3

FIG.4